# EUROPÄISCHE PATENTANMELDUNG

(11) **EP 1 363 329 A2**
(43) Veröffentlichungstag der Anmeldung: **19.11.2003**
(21) Anmeldenummer: 03010994.6
(22) Anmeldetag: 16.05.2003
(51) Int. Cl.: H01L 27/02

(54) **Schutzstruktur gegen elektrostatische Entladungen**

(30) Priorität: 18.05.2002 DE 10222306
(71) Anmelder: Micronas GmbH, 79108 Freiburg (DE)
(72) Erfinder: Czech, Martin, Dipl.-Ing., 79117 Freiburg (DE); Wagner, Eckart, Dipl.-Ing., 79270 Vörstetten (DE); Gahle, Hans-Jürgen, Dr.-Ing., 79312 Emmendingen (DE)
(74) Vertreter: Sauer, Wolfgang, Dipl.-Ing.

(57) **Zusammenfassung**

Schutzstruktur gegen elektrostatische Entladungen in Ein- und/oder Ausgangsstufen, mit einem MOS-Transistor (1) von einem ersten Leitungstyp. Dieser weist eine mit einem Massepotential (M) verbundene Sourcezone (z1) und eine dem ersten Leitungstyp entsprechende Drainzone (z2) und ein zugehörige Gateelektrode G auf. Die Drainzone (z2) ist gegenüber der normalen Transistorauslegung verlängert, um einen definierten Drainbahnwiderstand (wd) zwischen einer Drain-Gatekante und einer Drainkontaktierungszone (kd) zu bilden. Mindestens diejenigen Rand- oder Eckbereiche der Drainzone (z2), die unter einer Zuleitung (Ld) liegen, sind in einer oder mehreren Wannen (W2; W1) vom ersten Leitungstyp eingebettet. Die im Substat (2) liegenden Wannen (W2; W1) sind über die darin liegenden Drainzonen (z2) mit derem Potential verkoppelt.

## Beschreibung

Die Erfindung betrifft die Verbesserung einer Schutzstruktur gegen elektrostatische Entladungen in Ein- und Ausgangsstufen von monolithisch integrierten Schaltungen (= IC) mit MOS-Transistoren. Insbesondere sind hiervon Ein- und Ausgangsstufen in schnellen CMOS-Schaltungen betroffen, weil die einzelnen Transistoren sehr niederohmig sind und daher bei der elektrostatischen Entladung relativ hohe Ströme fließen. Diese Ströme können zu Zerstörungen im Kristallgefüge führen. Elektrostatische Entladungen, oft in Kurzform als "ESD" (=electro-static discharge) bezeichnet, treten beim unsachgemäßen Handhaben der monolithisch integrierten Schaltung auf, beispielsweise durch einen elektrostatisch aufgeladenen Menschen oder durch aufgeladene Werkzeuge oder sonstige Gegenstände, deren Ladungen dann über ein oder mehrere Anschlußbeine dem IC zugeführt werden und über andere Anschlußbeine abfließen können.

Ein MOS-Transistor beinhaltet immer auch einen parasitären Bipolartransistor. Beispielsweise entspricht bei einem n-Kanaltransistor im p-leitenden Substrat die n-leitende Drainzone dem Kollektor, die p-leitende Kanalzone der Basis und die n-leitende Sourcezone dem Emitter eines lateralen npn-Transistors. Diesem Transistor kann eine Schutzwirkung gegenüber Überspannungen zukommen, sofern die Sourceelektrode niederohmig mit dem Substrat und dem Masseanschluß verbunden ist. In diesem Fall liegt der Emitter des parasitären npn-Transistors auf Massepotential. Bei einem ESD-Ereignis, bei dem die Drainelektrode durch eine externe Spannungsquelle auf ein sehr hohes Potential gezogen wird, kann ein Spannungsdurchbruch im Bereich der Kollektor-Basis-Sperrschicht den lateralen npn-Transistor durchzünden, wodurch ein sehr niederohmiger Zustand erreicht wird. Im Bereich des Kollektor-Basisdurchbruchs wird durch den Entladungsstrom das ursprünglich auf Masse liegende Potential des Substrats lokal soweit angehoben, daß der laterale npn-Transitor leitend wird. Dieser Effekt wird auch als "snap-back"-Zustand bezeichnet. Die Schutzwirkung nutzt diesen niederohmigen "snap-back"-Zustand aus, weil über diesen Strompfad ein Teil der vom ESD-Ereignis stammenden Ladung auf unschädliche Weise nach Masse abfließen kann, ohne Teile der monolithisch integrierten Schaltung zu zerstören.

Leider ist, wie von bipolaren Leistungstransistoren bekannt, dieser "snap-back"-Zustand thermisch nicht stabil. Denn durch den Stromfluß erwärmt sich der lokal aktivierte Teiltransistor, wodurch er immer mehr Kollektorstrom auf sich zieht. Schließlich wird die lokale Wärmentwicklung so groß, daß der Kristall aufschmilzt. Die nahe Metallkontaktierung und metallischen Zuführungsleitungen begünstigen diesen fatalen Ausfallmechanismus, weil beispielsweise das Aluminium-Sililzium-Eutektikum schon bei 577° C schmilzt. Die Kontakte legieren dadurch sehr leicht in das Substrat ein. Das IC zeigt im Betrieb dann als Fehler einen Leckstrom oder gar einen Kurzschluß an dem zugehörigen Drainanschluß gegen das Substrat.

In US 5,021,853 sind die auftretenden Zerstörungsmechanismen derartiger ESD-Folgen auf Ein- und Ausgangstufen von CMOS-Schaltungen beschrieben. Ausführlich wird auch die Funktion des lateralen Bipolartransistors im "snap-back"-Betrieb als Schutzelement erläutert. Die thermische Stabilität im "snap-back"-Betrieb wird durch eine deutliche Vergrößerung der Drainzone erreicht, die durch den zusätzlichen Bahnwiderstand eine gleichmäßige Stromverteilung über den Spannungsdurchbruchsbereich an der Drain-Gatekante bewirkt. Die zusätzliche Drainzone ist dabei typischerweise 1 bis 3 mal so groß wie bei einer Standardauslegung des Transistors.

Ein Nachteil dieser Lösung ist die technologische Identität zwischen dem unerwünschten Spannungsdurchbruch zwischen der Drain-Kontaktkante und dem Substrat und dem erwünschten Spannungsdurchbruch zwischen der Drain-Gatekante und dem Substrat, da an beiden Sperrschichten etwa die gleichen Dotierungsverhältnisse zwischen Drain und Substrat vorliegen. Der Spannungsdurchbruch erfolgt zunächst dort, wo der Feldstärkegradient am höchsten ist. Das hängt von der Geometrie des Transistors und seiner Zuleitungen und von zufälligen Streuungen bei der Herstellung ab. Da der unerwünschte Abbruch an der Drain-Kontaktkante infolge der lokalen Gegebenheiten, die insbesondere bei Mehrfingerstrukturen von Leistungstransistoren auftreten können, nicht sicher vermeidbar ist, kann es hin und wieder vor dem eigentlichen Zünden der lateralen Schutzstruktur doch zu Spannungsdurchschlägen im Bereich der Drainkontaktierung zum Substrat kommen, die dort zu den bereits beschriebenen Aufschmelzungen führen, die zunächst relativ gering sind, schließlich aber doch zum Ausfall führen.

In der eigenen Patentanmeldung EP 0 691 683 A2 (intern: C-1649) wird ebenfalls die laterale Schutzstruktur eines Bipolartransistors zum Schutz der Ein- und Ausgangsstufen verwendet. Die gleichmäßige Stromverteilung beim Spannungsdurchbruch an der Drain-Gatekante wird dadurch erreicht, daß die Drainzone in eine Kontaktierungszone und eine eigentliche Drainzone aufgeteilt wird und mittels einer dazwischen liegenden Wanne gleicher Leitfähigkeit, aber deutlich geringerer Dotierung, eine Widerstandszone gebildet wird. Diese Anordnung hat den Vorteil, daß der Spannungsdurchbruch von der Oberfläche mehr in die Tiefe des Halbleiterkristalls gelegt wird. Dies vermeidet lokale Streuungen der Durchbruchspannung infolge von Oberflächeneffekten und die Spannungsfestigkeit nimmt durch die geringere Dotierung in der Tiefe zu.

Ein Nachteil dieser Wannenlösung ist jedoch der relativ hohe Wannenwiderstand, der im Normalbetrieb in Reihe zum Drain-Sourcestrompfad liegt und beim üblichen Schalterbetrieb den Ein-Widerstand des MOS-Transistors erhöht. Ein weiterer Nachteil für den Normalbetrieb ist die Nichtlinearität des Wannenwiderstandes durch den Abschnüreffekt, den "pinch-off"-Effekt, und den Geschwindigkeitssättigungseffekt der Elektronen. Ein zusätzlicher Nachteil ergibt sich gegebenenfalls aus der Geometrie bei der Auslegung als MOS-Leistungstransistor. In der Praxis werden zur Verringerung des Ein-Widerstandes mehrere Teiltransistoren zu einem Verband zusammengeschaltet. Dies kann prinzipiell die Schutzwirkung erhöhen, aber nur dann, wenn alle Teiltransistoren gleichzeitig zünden. Wie später noch anhand der Figuren gezeigt wird, ist der Verbindungsweg zwischen den einzelnen Teiltransistoren bei der Wannenlösung deutlich größer als bei der Lösung mit der vergrößerten Drainzone. Die n-leitende Wanne kann von Löchern, die das Zünden bewirken sollen, nicht passiert werden, zudem ist sie in der Regel sehr tief implantiert, so daß der Weg unter der Wanne hindurch ist sehr lang wird. Bei der Wannenlösung sind also Zündprobleme zu erwarten, wodurch die Schutzfunktion beeinträchtigt wird.

In EP 0 691 683 A2 ist ferner beschrieben, wie die laterale Schutzstruktur zum Schutz eines reinen Einganges einer monolithisch integrierten Schaltung verwendet werden kann. Hierzu wird die Drainzone der Schutzstruktur über ihren Anschluß niederohmig mit einem Eingangselement, z.B. einer Gateelektrode eines Transistors, verbunden. Die Gateelektrode der Schutzstruktur wird dabei auf das Sourcepotential gelegt, das üblicherweise auf Masse liegt. Ähnlich ist ein Schutz zwischen Versorgungsleitungen, insbesondere der positiven Versorgungsleitung und der Masse, oder einer Teilschaltung innerhalb der monolithisch integrierten Schaltung durchführbar.

Es ist Aufgabe der in den Ansprüchen gekennzeichneten Erfindung, eine verbesserte Schutzstruktur für Ein- und Ausgangsstufen von monolithisch integrierten Schaltungen unter Verwendung der lateralen Schutzwirkung eines MOS-Transistors anzugeben.

Die Lösung der Aufgabe erfolgt entsprechend den Merkmalen des Anspruchs 1 durch eine Schutzstruktur mit einem MOS-Transistor von einem ersten Leitungstyp, der eine mit dem Massepotential verbundene Sourcezone und eine Drainzone aufweist, deren Leitungstyp dem ersten Leitungstyp entsprechen. Die Drainzone enthält einen Kontaktierungszone, der die Drainzone an eine meist metallische Zuleitung anschließt, über die elektrostatische Ladungen niederohmig auf die zugehörige Ein- und/oder Ausgangsstufe gelangen. Die Drainzone ist gegenüber der normalen Transistorauslegung zur Bildung eines beim Spannungsdurchbruch wirksamen Bahnwiderstandes zwischen der zugehörigen Drain-Gatekante und der Kontaktierungszone vergrößert. Mindestens Teile der Drainkontaktierungszone, insbesondere diejenigen Eck- oder Randbereiche der Drainzone, die unter der Zuleitung liegen, sind in einer Wanne oder mehreren Wannen vom ersten Leitungstyp eingebettet. Die eine Wanne oder mehreren Wannen liegen dabei in einer den MOS-Transistor umgebenden und an das Massepotential angeschlossenen Zone von einem zweiten Leitungstyp. Das Potential der jeweiligen Wanne ist mit dem Potential der zugehörigen Drainzone verkoppelt.

Ein wesentlicher Vorteil der Schutzstruktur nach der Erfindung ist, daß sie mit den üblichen Herstellungsverfahren für CMOS-Schaltungen kompatibel ist, und daß sie Eingangs-, Ausgangsund kombinierte Ein-und-Ausgangsstufen sicher schützen kann. Bei Ausgangsstufen wird deren Innenwiderstand nur unwesentlich erhöht. Zudem ist die Schutzstruktur sowohl mit einem p-leitendem als auch mit einem n-leitendem Substrat realisierbar.

Die Erfindung und vorteilhafte Ausführungsbeispiele werden nun anhand der Figuren der Zeichnung näher erläutert. Es zeigen:
Fig. 1 schematisch in Aufsicht eine bekannte MOS-Transistorstruktur,
Fig. 2 im Querschnitt die zur Schnittlinie AB gehörigen Halbleiterzonen,
Fig. 3 das Ersatzschaltbild des parasitären npn-Transistors,
Fig. 4 eine Strom-Spannungs-Abbruchkennlinie,
Fig. 5 eine erste bekannte MOS-Schutzstuktur,
Fig. 6 das zugehörige Ersatzschaltbild des parasitären npn-Transistors,
Fig. 7 eine zweite bekannte MOS-Schutzstruktur,
Fig. 8 im Querschnitt die zur Schnittlinie EF gehörigen Halbleiterzonen,
Fig. 9 lokale Aufschmelzungen im Kontaktbereich der Drainzone,
Fig. 10 schematische Darstellung des Zündstrompfades bei der ersten bekannten Schutzstruktur,
Fig. 11 schematische Darstellung des Zündstrompfades bei der zweiten bekannten Lösung,
Fig. 12 ein erstes Ausführungsbeispiel der Erfindung,
Fig. 13 ein Ausführungsbeispiel bei einem Mehrfingertransistor,
Fig. 14 ein weiteres Ausführungsbeispiel bei einem Mehrfingertransistor.

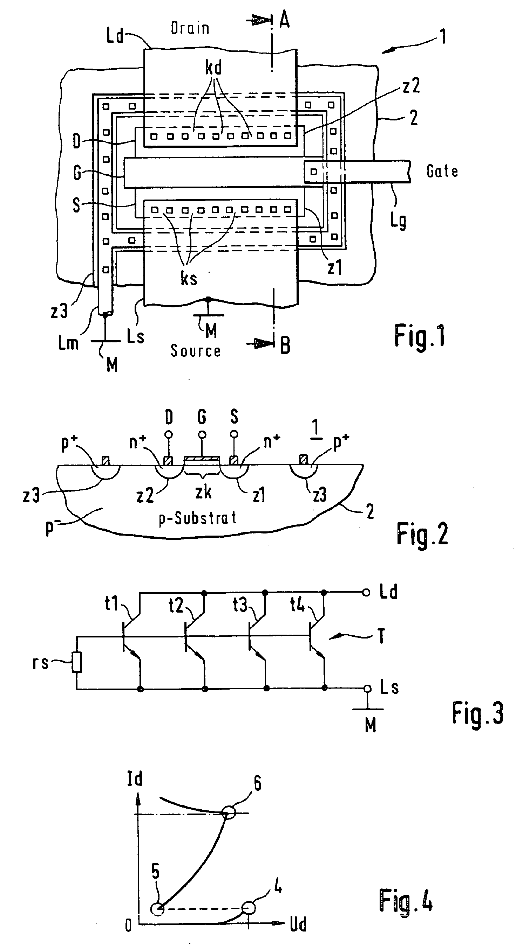

Fig. 1 zeigt schematisch in Aufsicht einen typischen n-Kanal-Leistungstransistor 1 innerhalb seines schwach p-leitenden Substrats 2 mit seiner Source- S, Gate- G und Drainelektrode D sowie der schwach p-leitenden Kanalzone zk (siehe Fig. 2) unterhalb der Gateelektrode G. Die Zuleitungen aus Alu zu den Elektroden bilden eine Drainleitung Ld, eine Gateleitung Lg und eine an Masse M angeschlossene Sourceleitung Ls. Die Source- und Drainelektrode bestehen aus hochdotiertem n-Material, das die Halbleiterzonen z1 bzw. z2 (siehe Fig. 2) bildet. Über der dazwischen liegenden Gate- oder Kanalzone zk befindet sich die durch eine dünne Oxidschicht getrennte Gateelektrode G aus Metall, Polysilizium oder einem anderen gut leitenden Material, an das über einen Kontakt eine Gateleitung Lg aus Alu angeschlossen ist. Das Substrat 2 ist mittels einer ringförmigen, hochdotierten p-leitenden Zone z3 und einer Leitung Lm niederohmig an das Massepotential M angeschlossen. Der Anschluß der Source- und Drainzone z1, z2 an die zugehörigen Leitungen Ls, Ld erfolgt jeweils über eine Kontaktierungszone kd mit einer Vielzahl von Einzelkontakten wie in Fig. 1 oder über längliche oder flächige Kontakte.

In Fig. 2 ist auf übliche Weise ein schematisches Schnittbild des MOS-Transistors 1 von Fig. 1 entlang der Schnittlinie AB dargestellt. In die Oberfläche des p-leitende Substrats 2 sind die relativ flachen Zonen z1, z2 aus n⁺-leitendem Material für die Source- und Drainelektrode S bzw. D eingebettet. Dazwischen befindet sich über einer dünnen Isolierschicht aus Oxidmaterial die Gateelektrode G und unter der Oxidschicht die schwach p-leitende Kanalzone zk. Von der ringförmigen Substratkontaktierung von Fig. 1 sind im Schnitt die beiden relativ flachen Zonen z3 erkennbar, die aus p⁺-leitendem Material bestehen und das schwach dotierte Substrat 2 kontaktieren. Der besseren Übersicht wegen sind die metallischen Zuleitungen Ls, Lg, Ld und Lm zu den Elektroden S, G, D und zur Zone z3 nicht dargestellt.

Fig. 3 zeigt das Ersatzschaltbild eines mit dem MOS-Transistor 1 von Fig. 1 und Fig. 2 verknüpften parasitären npn-Transistors T. Die eng beieinander liegenden n⁺-Gebiete der Drain- und Sourcezone z2, z1 bilden zusammen mit dem schwach p⁻-leitenden Substrat 2 unter der Gateelektrode G einen lateralen npn-Transistor, wobei die Drainzone z2 dem Kollektor, das Substrat 2, insbesondere in der Kanalzone zk, der Basis und die Sourcezone z1 dem Emitter entsprechen. Im normalen Betriebsfall ist dieser Transistor T allerdings nicht aktiv, da seine Basis durch die Erdung des Substrats 2 auf gleichem Potential wie der Emitter liegt und damit gesperrt ist. Der flächigen Struktur des Leistungstransistors 1 entspricht die Aufteilung des lateralen npn-Transistors T in 4 parallelgeschaltete Teiltransistoren t1 bis t4. Diese Aufteilung in vier Teiltransistoren ist nur schematisch zu verstehen und dient der Verdeutlichung, daß es sich hier um ein flächiges Geschehen handelt. Die gemeinsame Basis ist dabei über einen Widerstand rs mit der Masse M verbunden. Dies stellt den Substratwiderstand dar, der zwischen dem effektiven Basisgebiet unter der Gateelektrode G und dem eigentlichen Masseanschluß des Substrats 2 liegt und wegen der relativen Hochohmigkeit des Substrats für die Schutzfunktion zu beachten ist.

Fig. 4 zeigt schematisch die Strom-Spannungskennlinie Id = f(Ud) bei einem ESD-Ereignis an einem ungeschützten MOS-Transistor, beispielsweise entsprechend Fig. 1. Wenn durch eine externe elektrostatische Ladung an der Drainelektrode D eine genügend hohe positive Drainspannung Ud vorhanden ist, dann erfolgt bei einem durch die Geometrie und Herstellungsparameter definierten Spannungswert 4 ein Spannungsdurchbruch an der Sperrschicht zwischen der n⁺-leitenden Drainzone z2 und dem p⁻-leitenden Substrat 2. Der Durchbruch erfolgt dort, wo die Feldstärke am höchsten ist, das ist in der Regel im Gatebereich. Durch den Spannungsdurchbruch an der Drain-Gatekante gerät der laterale npn-Transistor in den niederohmigen "snap-back"-Zustand, vergl. den Bereich 5-6 der Id-Ud-Kennlinie von Fig. 4. Jetzt kann die elektrostatische Ladung rasch nach Masse abfließen. Leider ist dieser Zustand thermisch nicht stabil, d.h. wenn einer der aktivierten Teiltransistoren t1 bis t4 von Fig. 3 zufällig einen etwas größeren Drainstrom Id aufweist, erwärmt er sich stärker als die anderen Teiltransistoren. Dadurch sinkt seine Flußspannung und er wird entsprechend dem weiteren Verlauf der Id-Ud-Kennlinie noch mehr Strom der anderen Teiltransistoren übernehmen. Schließlich wird die Wärmeentwicklung so groß, daß der Kristall lokal mehr oder weniger aufschmilzt, vergl. Bereich 6. Dieser Vorgang 6 ist aber im Gegensatz zum "snap-back"-Zustand 5-6 nicht mehr reversibel, so daß eine bleibende Störung in der Halbleiterstruktur bestehen bleibt, die sich als als ein Leckstrom- oder Kurzschlußpfad zum Substrat hin im Betrieb bemerkbar macht. Die Kennlinie knickt daher bei Erreichen des Bereiches 6 ab.

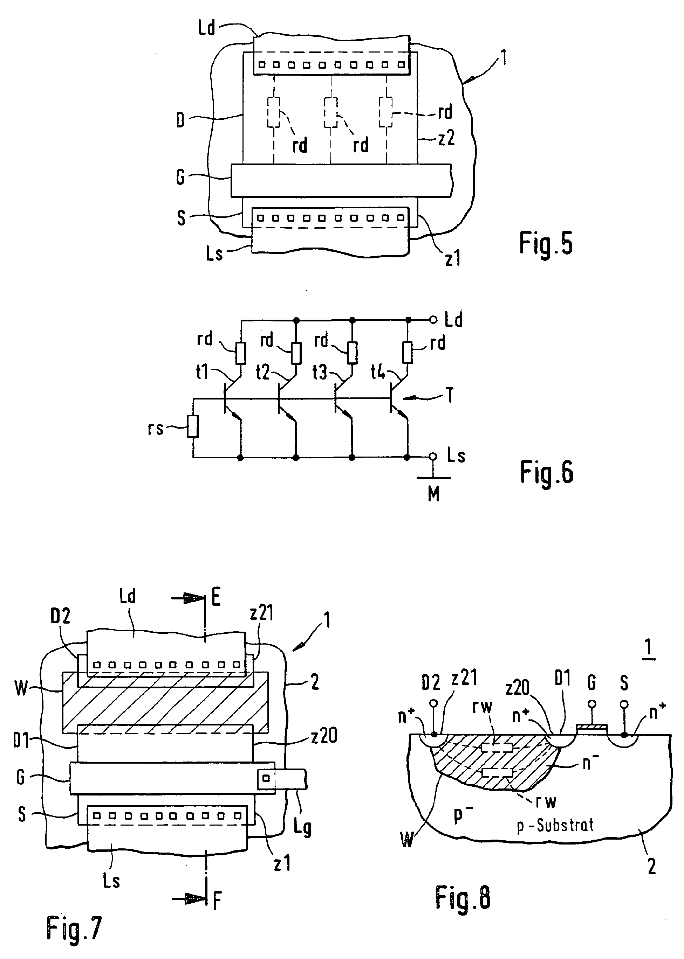

Fig. 5 zeigt die thermische Stabilisierung des MOS-Transistors 1 durch eine Vergrößerung der Drainzone z2, wie sie in US 5,021,853 beschrieben ist. Die Drainkontaktierungszone kd hat dabei einen deutlichen Abstand gegenüber der Drain-Gatekante und bildet dadurch die nicht mehr vernachlässigbaren Drain-Bahnwiderstände rd. Die Sourcezone z1 und die Gateelektrode G sind gegenüber Fig. 1 nicht verändert, so daß der MOS-Transistor im Normalbetrieb bis auf den etwas erhöhten Drain-Bahnwiderstand rd etwa identische Eigenschaften hat. Das zugehörige Ersatzschaltbild der vier Teiltransistoren t 1 bis t4 zeigt Fig. 6. Es enthält in den Kollektorzuleitungen der Teiltransistoren die zusätzlichen Drain-Bahnwiderstände rd.

Im MOS-Transistor 1 von Fig. 7 ist in Aufsicht die in US 5,021,853 beschriebene thermische Stabilisierung des MOS-Transistors 1 mittels einer n-leitende Wanne W zwischen den beiden getrennten Drainzonen z20, z21 dargestellt. Die Drain-Gatekante wird dabei von der n⁺-leitenden Zone z20 und die Drainkontaktierungszone von der n⁺-leitenden Zone z21 gebildet. Die anderen Einzelheiten entsprechen dem MOS-Transistor 1 von Fig. 1 und Fig. 5 und haben daher auch die gleichen Bezugszeichen. Die Struktur des Transistors 1 wird im Schnittbild von Fig. 8 besser erkennbar, das einer Schnittlinie EF in Fig. 7 entspricht. In Schraffur ist die Wanne W dargestellt, die als n-leitendes Element die beiden getrennten Drainzonen z20, z21 miteinander verbindet. Dem Bahnwiderstand der schwach n-dotierten Wanne W entsprechen die beiden gestrichelt dargestellten Wannenwiderstände rw.

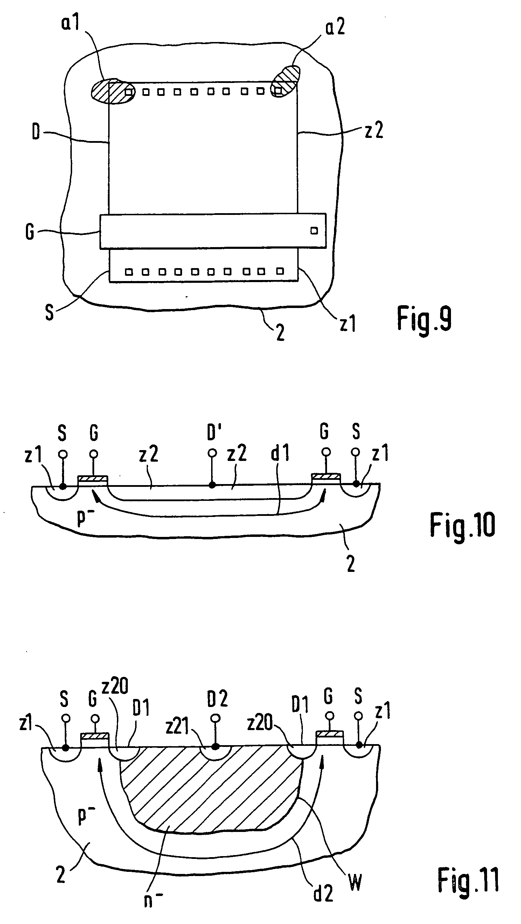

In Fig. 9 ist in Aufsicht ein Fig. 5 entsprechender MOS-Transitor 1 ohne die zugehörigen Alu-Leitungen Ld, Lg, Ls, Lm dargestellt. In den Eckbereichen der vergrößerten Drainzone z2 sind unerwünschte Aufschmelzungszonen a1, a2 zwischen der Metallisierung oder den Kontakten und dem Substrat dargestellt. Derartige Aufschmelzungen, die auch bei der bekannten Maßnahme nach Fig. 7 entstehen können, treten auf, wenn das für den "snap-back"-Zustand gewünschte Durchzünden gleichzeitig oder später eintritt als das unerwünschte Durchzünden an der Drain-Kontaktkante, das wie bereits erwähnt am ehesten in den Randzonen unter den metallischen Leitungen erfolgt, weil dort ein hohes Potentialgefälle vorhanden ist. Dies wird auch noch durch den Bahnwiderstand rd bzw. rw der vergrößerten Drainzone z2 bzw. der Wanne W im Durchzündfall verstärkt, weil die Drainleitung Ld dann gegenüber der Drain-Gatekante ein höheres Potential aufweist. Beim Durchzünden an diesen kritischen Stellen entstehen schließlich diese Aufschmelzungen a1, a2.

In Fig. 10 und Fig. 11 wird die Wirksamkeit der Schutzwirkung nach Fig. 5 und Fig. 7 miteinander verglichen. Es handelt sich dabei jeweils um vereinfachte Schnittbilder bei Mehrfingerstrukturen des MOS-Transistors 1, die mehrere nebeneinanderliegenden MOS-Teiltransistoren enthalten, hier jeweils zwei mit einem zentralen Drainanschluß D' bzw. D2. Bei den vergrößerten Drainzonen z2 von Fig. 10 kann eine Schutzwirkung des einen Teiltransistors auf den anderen nur erfolgen, wenn die beiden Gebiete unter den Gates G genügend niederohmig über das Substrat 2 miteinander verbunden sind. Der resultierende Strompfad für die Ladungsträger im Substrat wird durch die Doppelpfeile d1, d2 symbolisiert. Wird durch das Durchzünden der Drain-Gatekante des einen npn-Teiltransistors das Substrat dort im Potential angehoben, dann hängt ohne eigenes Durchzünden das Basispotential des anderen npn-Teiltransistors von dem Weg und dem Bahnwiderstand im Substrat ab. Wenn beides zu groß ist, zünden die npn-Teiltransistoren nicht zusammen oder einer oder mehrere Teiltransistoren zünden gar nicht (= shut off). Damit bleibt aber ihre Schutzwirkung begrenzt. Die schematische Schnittbilddarstellung Fig. 11, die der bekannten Wannenlösung von Fig. 7 entspricht, zeigt, daß hierbei die Verhältnisse sehr viel ungünstiger als bei Fig. 10 sind. Denn durch die tiefe Wanne W ist der Weg d2 von dem einen npn-Teiltransistor zum anderen wesentlich länger geworden.

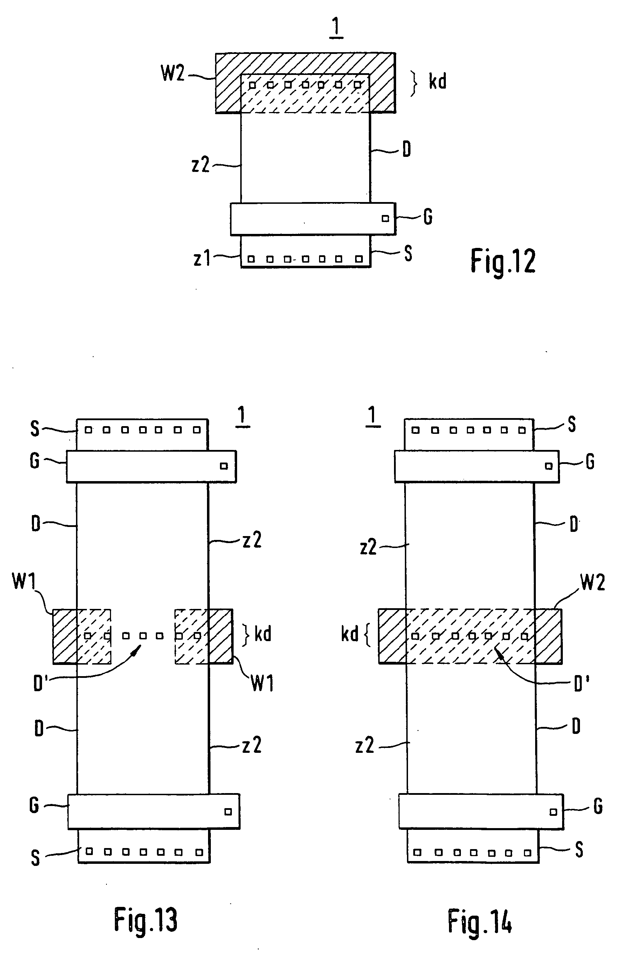

Die Fig. 12 bis Fig. 14 zeigen in Aufsichtdarstellung verschiedene Ausführungsbeispiele der MOS-Schutzstruktur nach der Erfindung. Die genannten Probleme des unerwünschten oberflächigen Spannungsabbruches der Drainzone nahe den Drainkontakten sind dabei sicher beseitigt. Durch eine Wanne W1, W2 gleichen Leitungstyps wie die vergrößerte Drainzone z2, wobei sich die Wanne mit den üblichen CMOS-Herstellungsverfahren ohne zusätzlichen Prozessaufwand herstellen läßt, kann die Drainzone innerhalb der Wanne eine höhere Abbruchspannung realisieren als ohne Wanne. Das "Wettrennen" zwischen dem erwünschten und unerwünschten Spannungsabbruch an der Drain-Gatekante bzw. Drainkontaktkante tritt so nicht mehr auf. Die Wannen können dabei die gefährdeten Gebiete wie Fig. 13 mit den Teilwannen W1 teilweise oder wie in Fig. 12 und Fig. 14 mit der Wanne W2 ganz umschließen. Da die Wannen W1 bzw. W2 nur um und unterhalb der gefährdeten Kontakte angebracht werden und die Drainzonen z2 im Layout nicht verändert sind, ergeben sich keine nachteiligen parasitären Wannenwiderstände oder sonstige parasitären Widerstände. Für die verbesserten Schutzmaßnahmen ist keine zusätzliche Chipfläche erforderlich oder der Zusatzbedarf ist allenfalls unwesentlich. Die parasitären Kapazitäten werden ebenfalls nicht vergrößert. Fig. 12 zeigt einen einzelnen MOS-Leistungstransistor mit jeweils einer einzigen Gateelektrode G. Fig. 13 und Fig. 14 zeigen jeweils einen MOS-Leistungstransistor in Doppelausführung, mit einem zentralen Drainanschluß D'unter dem die beiden Teilwannen W1 oder die durchgehende Wanne W2 liegt. Beidseitig zu diesem zentralen Drainanschluß D' schließt sich eine vergrößerte Drainzone z2 an, der dann je eine Gateelektrode G und zugehörige Sourceelektrode S folgt. Die Zuleitungen und Metallisierungen sind der besseren Übersicht wegen in den Fig. 12 bis 14 nicht dargestellt. Sie ergeben sich jedoch ohne weiteres aus den vorausgehenden Figuren. Der Leitungstyp der Wannen W1, W2 ist entgegengesetzt zum Leitfähigkeitstyp des Substrats.

## Patentansprüche

1. Schutzstruktur gegen elektrostatische Entladungen in Ein- und/oder Ausgangsstufen, wobei
- die Schutzstruktur einen MOS-Transistor (1) von einem ersten Leitungstyp enthält, der eine mit einem Massepotential (M) verbundene Sourcezone (z1) und eine Drainzone (z2) aufweist,
- die Drainzone (z2) eine Drainkontaktierungszone (kd) enthält, der die Drainzone an eine Zuleitung (Ld) anschließt, über die elektrostatische Ladungen niederohmig auf die zugehörige Ein- und/oder Ausgangsstufe gelangen, und
- die Drainzone (z2) gegenüber der normalen Transistorauslegung zwischen einer Drain-Gatekante und der Drainkontaktierungszone (kd) verlängert ist, **gekennzeichnet durch** folgende Merkmale:
- mindestens Teile der Drainkontaktierungszone (kd), insbesondere diejenigen Rand- oder Eckbereiche der Drainzone (z2), die unter der Zuleitung (Ld) liegen, sind in einer oder mehreren Wannen (W2; W1) vom ersten Leitungstyp eingebettet,
- die eine oder mehreren Wannen (W2; W1) liegen dabei in einer den MOS-Transistor (1) umgebenden und an das Massepotential (M) angeschlossene Zone (2), insbesondere dem Substrat, von einem zweiten Leitungstyp und
- das Potential der jeweiligen Wanne (W1; W2) ist mit dem Potential der zugehörigen Drainzone (z2) verkoppelt.

2. Schutzstruktur nach Anspruch 1, **dadurch gekennzeichnet, daß** die Kontaktierungszonen (kd, ks) der Drain- und Sourcezone (z2, z1) zum Anschluß an die jeweilige Zuleitung (Ld, Ls) entweder eine Vielzahl von Einzelkontakten oder eine längliche oder flächige Kontaktierung aufweist.

3. Schutzstruktur nach Anspruch 2, **dadurch gekennzeichnet, daß** die Ein- und/oder Ausgangsstufen monolithisch integrierte Transistoren in CMOS-Technik enthalten.
